# EUROPEAN PATENT APPLICATION

(11) **EP 2 733 747 A2**
(43) Date of publication of application: **21.05.2014**
(21) Application number: 13187594.0
(22) Date of filing: 07.10.2013
(51) Int. Cl.: H01L 31/0224, H01L 31/052, H01L 31/0749

(54) **Solar cell**

(30) Priority: 15.11.2012 US 201261726982 P; 19.09.2013 US 201314032135
(71) Applicant: Samsung SDI Co., Ltd., Yongin-si, Gyeonggi-do (KR)
(72) Inventor: Jung, Seung-Jae, Gyeonggi-do (KR)
(74) Representative: Mounteney, Simon James

(57) **Abstract**

A solar cell (100) includes a substrate (110), a back surface electrode layer (120) formed on the substrate, in which a 1a-th through-region (121) is formed, a transparent electrode layer (130) formed on the back surface electrode layer, in which a 1b-th through-region (131) is formed at a position corresponding to the la-th through-region, and a light absorbing layer (140) formed on the transparent electrode layer. Accordingly, the solar cell can be implemented to be thin, and the power generation efficiency of the solar cell can be improved.

## Description

### BACKGROUND

### 1. Field

An aspect of the present invention relates to a solar cell.

### 2. Description of the Related Art

As demands on energy increase, demands on solar cells for converting solar energy into electrical energy have recently been increased. Solar cells are clean energy sources that produce electricity from the sun as an infinite energy source. Solar cells have come into the spotlight recently as new growth engine with a high industrial growth rate every year.

A copper-indium-gallium-(di)selenide (CIGS) solar cell is a solar cell that can be implemented as a thin film and does not use Si. Thus, it is expected that the CIGS solar cell will play an important role in the spread of solar energy by lowering the production cost of solar cells. Further, it is known that since CIGS solar cells are thermally stable, a decrease in efficiency hardly occurs as time elapses. Therefore, various studies have been conducted to increase the power-generating capacity of CIGS solar cells.

In particularly, there is a demand for improving power-generating capacity while fabricating a thin CIGS solar cell.

### SUMMARY

Embodiments provide a solar cell capable of improving power generation efficiency while being implemented to be thin.

According to an aspect of the present invention, there is provided a solar cell, including: a substrate; a back surface electrode layer formed on the substrate in which a 1a-th through-region is formed; a transparent electrode layer formed on the back surface electrode layer in which a 1b-th through-region is formed at a position corresponding to the 1a-th through-region; and a light absorbing layer formed on the transparent electrode layer.

The 1a-th through-region is formed by patterning the back surface electrode layer, and the 1b-th through-region is formed by patterning the transparent electrode layer.

The transparent electrode layer is extended to cover the upper surface of the back surface electrode layer and the side surface of the back surface electrode layer exposed by the 1a-th through-region.

The transparent electrode layer is formed to extend on the upper surface of the substrate exposed by the 1a-th through-region. That is, the transparent electrode layer is formed to further extend on the upper surface of the substrate exposed by the 1a-th through-region, such that the transparent electrode layer covers an area of the substrate that is greater than the width of said transparent electrode layer that covers the side surface of the back surface electrode layer exposed by the 1a-th through-region.

The width of the 1b-th through-region is narrower than that of the corresponding 1a-th through-region.

The difference in width between the 1a-th through-region and the 1b-the through-region is 10µm or more.

The difference in width between the 1a-th through-region and the first through-region is 30µm or more.

In certain embodiments, the back surface electrode layer includes at least one of Ag, A1, Cu, Au, Pt and Cr.

In certain embodiments, the solar cell further includes an adhesion improving layer formed between the back surface electrode layer and the substrate.

In embodiments, the adhesion improving layer includes at least one of Ti, Cr, Mo and Ni.

In certain embodiments, the solar cell further includes a diffusion barrier layer formed between the back surface electrode layer and the substrate.

In embodiments, the diffusion barrier layer includes at least one of oxide and nitride materials.

In yet further embodiments, the diffusion barrier layer includes at least one of SiOₓ, SiNₓ, SiOₓN_{y}, Al₂O₃, AlOₓN_{y}, TiN, TaN and WN.

In still yet further embodiments, the diffusion barrier layer be formed between the back surface electrode layer and the substrate and on the upper surface of the substrate, exposed by the 1a-th through-region.

In certain embodiments, the solar cell further includes a contact resistance improving layer formed between the transparent electrode layer and the light absorbing layer.

The contact resistance improving layer includes at least one of MSeₓ and MSₓ (here, M is any one of Mo, W, Ta, Nb, Ti, Cr, V and Mn).

In certain embodiments, the solar cell further includes a buffer layer formed on the light absorbing layer, and a rear surface electrode layer formed on the buffer layer.

A first aspect of the invention relates to a solar cell as described in Claim 1. Embodiments of this first aspect may be found in Claims 2 to 14. A second aspect of the invention relates to a method for forming the solar cell according to Claims 1 to 14.

Other features and advantages of the present invention will become more fully apparent from the following detailed description, taken in conjunction with the accompanying drawings.

Terms or words used in this specification and claims should not be restrictively interpreted as ordinary meanings or dictionary-based meanings, but should be interpreted as meanings and concepts conforming to the scope of the presently claimed invention on the basis of the principle that an inventor can properly define the concept of a term to describe and explain his or her invention in the best way. For example, when used herein in embodiments of the invention, the terms "comprising", "comprises" and "comprise" can be interpreted as encompassing all the specifically mentioned features as well optional, additional, unspecified ones. However, these terms also cover the use of the terms "consists of", "consisting of", "consists essentially of" and "consisting essentially of" in said embodiments of the invention.

According to the solar cell of the present invention, a transparent electrode layer is formed between a back surface electrode layer and a light absorbing layer, so that it is possible to implement a thin solar cell and to improve power generation efficiency.

Further, the back surface electrode layer is configured as a high reflection electrode, thereby improving the re-absorption rate of the solar cell.

Further, the exposed back surface electrode layer is covered with the transparent electrode layer, so that it is possible to prevent selenization of the back surface electrode layer. Accordingly, it is possible to prevent a decrease in resistance of the back surface electrode layer, a peeling phenomenon and a defect caused by diffusion of the high reflection electrode into the light absorbing layer.

### BRIEF DESCRIPTION OF THE DRAWINGS

The accompanying drawings, together with the specification, illustrate embodiments of the present invention, and, together with the description, serve to explain the principles of the present invention.

FIG. 1 is a sectional view of a solar cell according to an embodiment of the present invention.

FIGS. 2 and 3 are sectional views comparing solar cells with the solar cell shown in FIG. 1.

FIGS. 4 to 6 are sectional views illustrating a fabricating method of the solar cell shown in FIG. 1.

FIG. 7 is a sectional view of a solar cell according to another embodiment of the present invention.

FIGS. 8 to 11 are sectional views of solar cells according to still other embodiments of the present invention.

### DETAILED DESCRIPTION

In the following detailed description, only certain embodiments of the present invention have been shown and described, simply by way of illustration. As those skilled in the art will realize, the described embodiments may be modified in various different ways, all without departing from the scope of the presently claimed invention. Accordingly, the drawings and description are to be regarded as illustrative in nature and not restrictive. In addition, when an element is referred to as being "on" another element, it can be directly on the another element or be indirectly on the another element with one or more intervening elements interposed therebetween. Also, when an element is referred to as being "connected to" another element, it can be directly connected to the another element or be indirectly connected to the another element with one or more intervening elements interposed therebetween. Hereinafter, like reference numerals refer to like elements.

Hereinafter, embodiments of the present invention will be described in detail with reference to the accompanying drawings.

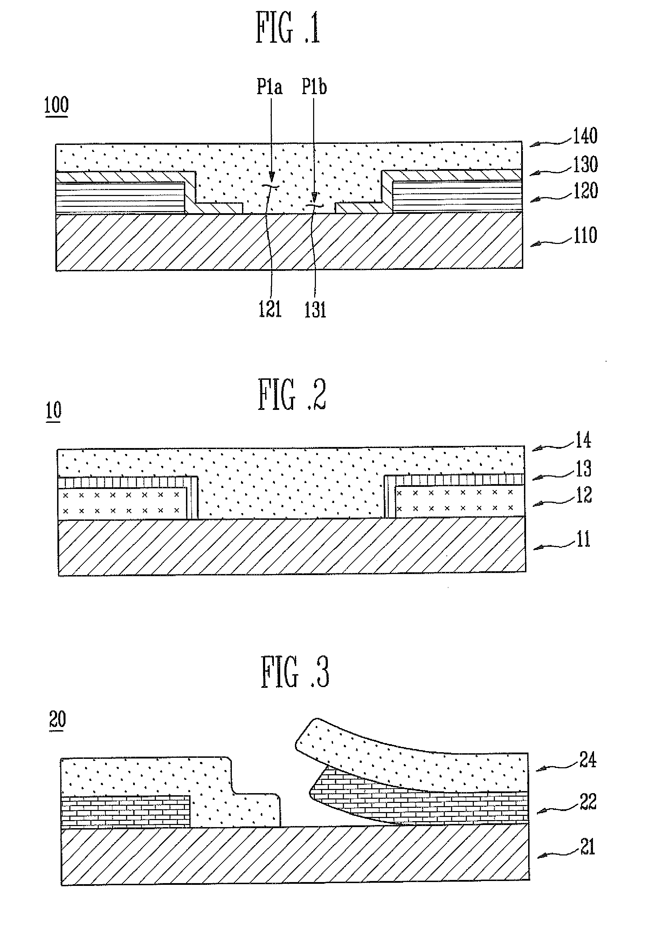

FIG. 1 is a sectional view of a solar cell 100 according to an embodiment of the present invention. Hereinafter, the solar cell 100 according to this embodiment will be described with reference to FIG. 1.

As shown in FIG. 1, the solar cell 100 according to this embodiment sequentially includes a substrate 110, a back surface electrode layer 120 in which a 1a-th through-hole 121 is formed, a transparent electrode layer 130 in which a 1b-th through-hole 131 is formed, and a light absorbing layer 140.

The substrate 110 is a member that provides a space in which the back surface electrode layer 120 and the transparent electrode layer 130 are formed. The substrate 110 becomes a base of the solar cell 100.

Here, the substrate 110 is a glass substrate, ceramic substrate, metal substrate, polymer substrate, etc. For example, the substrate 110 is a glass substrate including alkali elements such as Na, K and Cs therein. Preferably, the substrate 110 is a sodalime glass substrate or high strained point soda glass substrate.

The back surface electrode layer 120 is a member which is formed on the substrate 110, and includes the 1a-th through-region 121.

Here, the 1a-th through-hole 121 is formed in the back surface electrode layer 120 through a patterning process. The 1a-th through-region 121 means a through-hole or a space in which the patterned back surface electrode layers 120 are spaced apart from each other. In embodiments of the invention, the back surface electrode layer 120 is made of metal having excellent stability at a high temperature and high electrical conductivity. In this embodiment, the back surface electrode layer 120 is made of high reflection metal such as Ag, Al, Cu, Pt or Cr. In a case where the high reflection metal is used as the back surface electrode layer 120 in this embodiment, the reflectivity of light transmitted into the solar cell 100 is high even though the solar cell 100 is implemented to be thin. Thus, the amount of light reabsorbed in the solar cell 100 increases, thereby reducing current loss.

The transparent electrode layer 130 is a member formed on the back surface electrode layer 120 having the 1a-th through-region 121 formed therein.

Here, the 1b-th through-region 131 is formed in the transparent electrode layer 130 through a patterning process. The 1b-th through-region 131 is formed at a position corresponding to the 1a-th through-region 121. Thus, a portion of the substrate 110 is exposed by the 1b-th through-region 131, so as to contact the light absorbing layer 140. In this embodiment, the width of the 1b-th through-region 131 is narrower than that of the 1a-th through-region 121, and the difference in width between the 1a-th through-region 121 and the 1b-th through-region 131 is 10µm or more. Preferably, the difference in width between the 1a-th through-region 121 and the 1b-th through-region 131 is set to 30µm or more. In a case where the width of the 1b-th through-region 131 is narrower than that of the 1a-th through-region 121 as described above, the transparent electrode layer 130 is positioned to extend to the upper surface of the back surface electrode layer 120, the side surface of the back surface electrode layer 120, exposed by the 1a-th through-region 121, and a portion of the upper surface of the substrate 110, exposed by the 1a-th through-region 121. In this case, the reason why the transparent electrode layer 130 is positioned at a portion adjacent to the back surface electrode layer 120 on the upper surface of the substrate 110 is that the 1b-th through-region 131 is positioned to correspond to the 1a-th through-region 121. In embodiments of the current invention, the transparent electrode layer 130 is formed to have, for example, a thickness of 50 to 150nm. Particularly, the thickness of the transparent electrode layer 130 positioned at the exposed side surface of the back surface electrode layer 120 is, for example, 10nm or more in order to prevent a selenization reaction between the back surface electrode layer 120 and the light absorbing layer 140.

Although it has been described in this embodiment that the width of the 1b-th through-region 131 is narrower by 10µm or more than that of the 1a-th through-region 121, and therefore, the transparent electrode layer 130 is extended up to the exposed upper surface of the substrate 110, the present invention is not limited. Specifically, a case where the width of the 1b-th through-region 131 is implemented to be slightly narrower than that of the 1a-th through-region 121, so that the transparent electrode layer 130 is formed on only the upper and side surfaces of the back surface electrode layer 120 is included in the present invention.

Meanwhile, a transparent and conductive material is preferably used for the transparent electrode layer 130 in terms of the improvement of high reflectivity and refractive index, and the transparent electrode layer 130 is made of, for example, transparent conductive oxide (TOC). Specifically, the transparent electrode layer 130 is made of ZnO or ZnO doped with Al, Ga, B, etc. For example, the transparent electrode layer 130 is made of In₂O₃, SnO₂, TiO₂, etc.

The light absorbing layer 140 is a member which is formed on the transparent electrode layer 130 having the 1b-th through-region 131 formed therein.

The light absorbing layer 140 is a portion absorbing light, and is formed of a Group I-III-VI based compound semiconductor or Group I-II-IV-VI based compound semiconductor. Here, the Group I element is any one of Cu, Ag, Au, etc., and the Group II element is any one of Zn, Cd, etc. The Group III element is any one of In, Ga, Al, etc., and the Group IV element is any one of Si, Ge, Sn, Pb, etc. The Group VI element is any one of S, Se, Te, etc.

Specifically, the Group I-III-VI based compound semiconductor is, for example, a compound semiconductor such as CIS, CGS or CIGS (here, C denotes copper (Cu), I denotes indium (In), G denotes gallium (Ga), and S denotes one or more of sulfur (S) and selenium (Se)). The Group I-II-IV-VI based compound semiconductor is a compound semiconductor such as CZTS (here, C denotes copper (Cu), Z denotes zinc (Zn), T denotes tin (Sn), and S denotes one or more of sulfur (S) and selenium (Se)).

FIGS. 2 and 3 are sectional views comparing prior art solar cells with the solar cell 100 shown in FIG. 1. Hereinafter, the solar cell 100 according to this embodiment will be described in a more detailed manner with reference to the prior art embodiments shown in FIGS. 2 and 3.

As shown in FIG. 2, a general back surface electrode layer 12 formed on a substrate 11 of a solar cell 10 is made of molybdenum (Mo). Here, the Mo is stable under the selenization atmosphere of a light absorbing layer 14, but the reflectivity of the Mo is relatively low. Therefore, in a case where the thickness of the solar cell 10 is implemented to be thin, the re-absorption of light is inferior. Particularly, in a case where the solar cell 10 is implemented to have a thickness of 1µm or less, current loss of a few mA/cm² is expected. Here, reference numeral 13 denotes an alloy layer, and corresponds to a layer formed by a selenization reaction between the Mo and the light absorbing layer 14.

To solve the problem of inferior light re-absorption caused by the use of Mo, a solar cell 20 using high reflection metal such as Ag as a back surface electrode layer 22 formed on a substrate 21 has been considered as shown in FIG. 3. However, a high reflection metal such as Ag is unstable under a selenization atmosphere of 400°C or more, and therefore, the entire back surface electrode layer 22 may be converted into AgSeₓ. In a case where the entire back surface electrode layer 22 is converted into AgSeₓ, the resistance of the back surface electrode layer 22 is lost, and the AgSeₓ has a low adhesive property with the substrate 21. Therefore, as shown in FIG. 3, a peeling phenomenon may occur in a subsequent process. The Ag of the back surface electrode layer 22 is diffused in a light absorbing layer 24 configured with CIGS, and therefore, a defect may occur in the light absorbing layer 24.

The solar cell 100 according to the currently described embodiment is derived from such a viewpoint, and all the problems described above can be solved in the solar cell 100 shown in FIG. 1.

Specifically, although the solar cell 100 according to this embodiment is implemented to have a thickness of 0.5µm or less using high reflection metal such as Ag or Al as the back surface electrode layer 120, current loss is low, thereby increasing the re-absorption rate of light. The transparent electrode layer 130 is formed after the 1a-th through-region 121 is formed in the back surface electrode layer 120, and thus it is possible to prevent the back surface electrode layer 120 and the light absorbing layer 140 from coming in direct contact with each other. Particularly, in this embodiment, the transparent electrode layer 130 is formed not only on the upper surface of the back surface electrode layer 120 but also the exposed side surface of the back surface electrode layer 120, so that it is possible to prevent, in advance, the high reflection metal such as Ag and the Se of the light absorbing layer 140 from reacting with each other through the exposed side surface of the back surface electrode layer 120. Thus, it is possible to prevent, in advance, the entire back surface electrode layer 120 from being transferred into AgSeₓ due to the reaction between Se and Ag through the exposed side surface of the back surface electrode layer 120. Accordingly, it is possible to prevent resistance loss due to the transfer of the back surface electrode layer into AgSeₓ, occurrence of a peeling phenomenon, occurrence of a defect, etc.

Meanwhile, the transparent electrode layer 130 is also formed on the upper surface of the substrate 110, exposed by the 1a-th through-region 121. This is because the width of the 1a-th through-region 121 is wider than that of the 1b-th through-region 131. In a case where the transparent electrode layer 130 is formed to extend up to the upper surface of the substrate 110, it is possible to more certainly prevent the high reflection metal from reacting with the Se of the light absorbing layer 140.

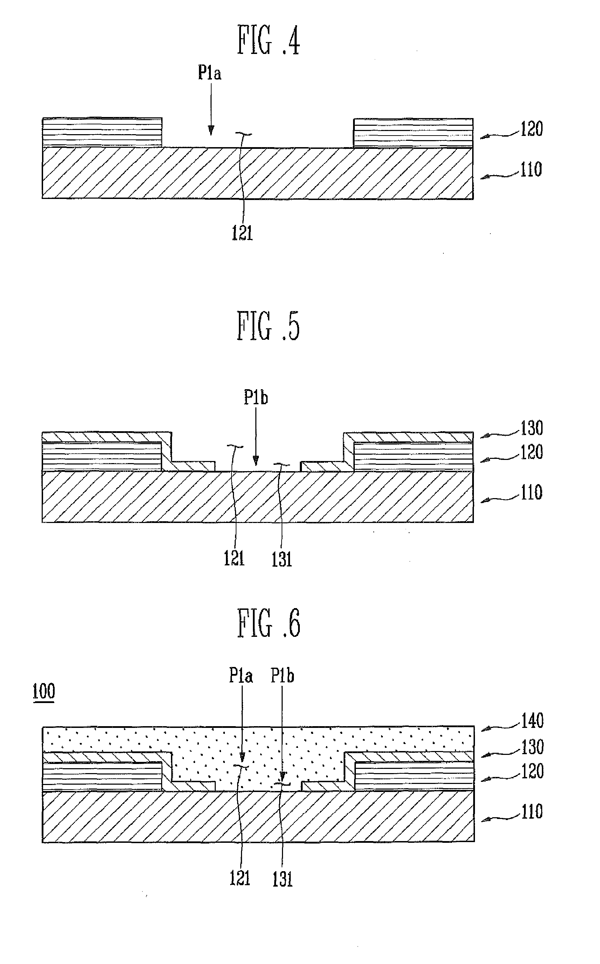

FIGS. 4 to 6 are sectional views illustrating a fabricating method of the solar cell 100 shown in FIG. 1. Hereinafter, the fabricating method of the solar cell 100 according to this embodiment will be described with reference to FIGS. 4 to 6.

First, as shown in FIG. 4, a patterned back surface electrode layer 120 is formed on the upper surface of a substrate 110.

In this case, a 1a-th through region 121 is formed in the back surface electrode layer through a patterning process, and a portion of the upper surface of the substrate 110 is exposed to the outside by the 1a-th through-region 121. The back surface electrode layer 120 is formed through a sputtering, deposition, plating or screen printing process, and the 1a-th through-region 121 is formed through, for example, a laser process.

Next, as shown in FIG. 5, a transparent electrode layer 130 is formed on the back surface electrode layer 120 having the 1a-th through-region 121 formed therein.

In this case, a 1b-th through-region 131 is formed in the transparent electrode layer 130 through a patterning process. The 1b-th through-region 131 is formed to correspond to the position at which the 1a-th through-region 121 is formed. The transparent electrode layer 130 is formed through a sputtering, deposition or chemical vapor deposition (CVD) process, and the 1b-th through-region 131 is formed through a laser process. In this case, the width of the 1b-th through-region 131 is narrower by 10 or more, preferably 30 or more than that of the 1a-th through-region 121, in consideration of mechanical tolerance according to the laser process.

Next, as shown in FIG. 6, a light absorbing layer 140 is formed on the transparent electrode layer 130 having the 1b-th through-region 131 formed therein, thereby fabricating the solar cell 100.

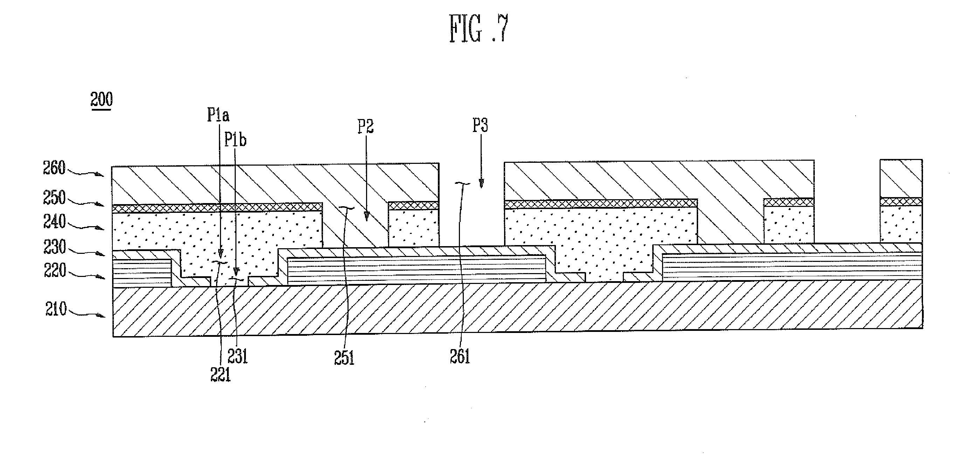

FIG. 7 is a sectional view of a solar cell 200 according to another embodiment of the present invention. Hereinafter, the solar cell 200 according to this embodiment will be described with reference to FIG. 7.

As shown in FIG. 7, the solar cell 200 according to this embodiment includes a substrate 210, a back surface electrode layer 220 in which a 1a-th through-region is formed, a transparent electrode layer 230 in which a 1b-th through-region 231 is formed, and a light absorbing layer 240, as shown in FIG. 1. In this embodiment, the solar cell 200 further includes a buffer layer 250 and a rear surface electrode layer 260.

The buffer layer 250 is formed with at least one layer on the light absorbing layer 240. Here, the light absorbing layer 240 formed beneath the buffer layer 250 acts as a p-type semiconductor, and the rear surface electrode layer 260 formed on the buffer layer 250 acts as an n-type semiconductor, so that a p-n junction can be formed between the light absorbing layer 240 and the rear surface electrode layer 260. The buffer layer 250 is formed to have a bandgap at a middle level between those of the light absorbing layer 240 and the rear surface electrode layer 260, so that an excellent junction between the light absorbing layer 240 and the rear surface electrode layer 260 can be implemented. For example, the buffer layer 250 is made of CdS, ZnS, etc. The buffer layer 250 is patterned together with the light absorbing layer 240. Accordingly, the buffer layer 250 includes a second through-region 251.

The rear surface electrode layer 260 is formed on the buffer layer 260. Here, the rear surface electrode layer 260 is a conductive layer, and acts as an n-type semiconductor. For example, the rear surface electrode layer 260 is made of TOC. Preferably, the rear surface electrode layer 260 is made of ZnO. The rear surface electrode layer 260 is also patterned together with the buffer layer 250 and the light absorbing layer 240. Accordingly, the rear surface electrode layer 260 includes a third through-region 261.

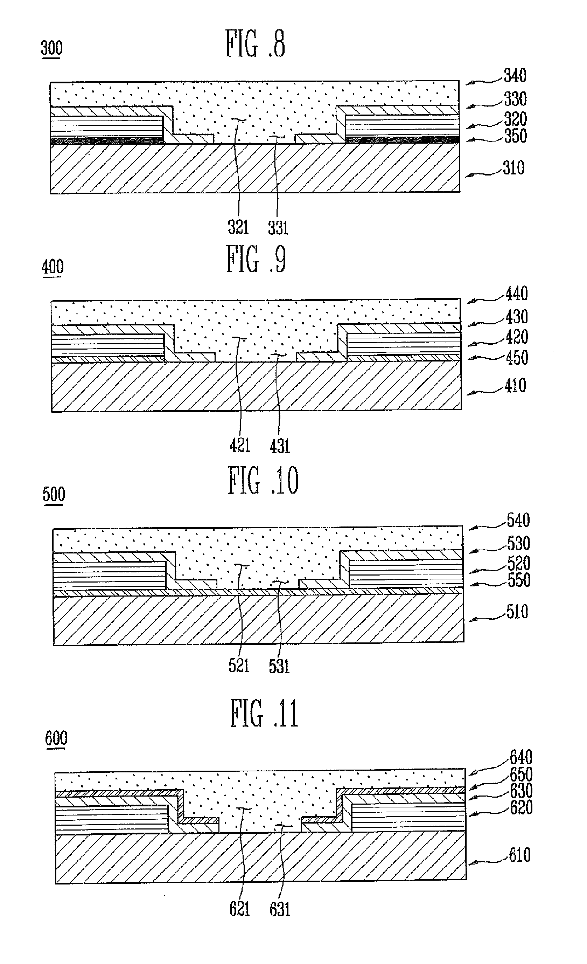

FIGS. 8 to 11 are sectional views of solar cells 300, 400, 500 and 600 according to still other embodiments of the present invention. Hereinafter, the solar cells 300, 400, 500 and 600 according to these embodiments will be described with reference to FIGS. 8 to 11.

First, as shown in FIG. 8, the solar cell 300 according to this embodiment includes a substrate 310, a back surface electrode layer 320 in which a 1a-th through-region 321 is formed, a transparent electrode layer 330 in which a 1b-th through-region 331 is formed, and a light absorbing layer 340, as described in FIG. 1. The solar cell 300 further includes an adhesion improving layer 350.

Here, the adhesion improving layer 350 is interposed between the back surface electrode layer 320 and the substrate 310. Specifically, the adhesion improving layer 350 is a member for improving the adhesion between the substrate 310 and the back surface electrode layer 320 made of high reflection metal. The adhesion improving layer 350 is formed between the substrate 310 and a portion at which the 1a-th through-region 321 is not formed in the back surface electrode layer 310. Here, the adhesion improving layer 350 includes at least one of Ti, Cr, Mo and Ni. The adhesion improving layer 350 is formed before the formation of the back surface electrode layer 320. The adhesion improving layer 350 is patterned together with the back surface electrode layer 320 when the 1a-th through-region 321 is formed after the formation of the back surface electrode layer 320.

As shown in FIG. 9, the solar cell 400 according to this embodiment includes a substrate 410, a back surface electrode layer 420 in which a 1a-th through-region 421 is formed, a transparent electrode layer 430 in which a 1b-th through-region 431 is formed, and a light absorbing layer 440, as described in FIG. 1. The solar cell 400 further includes a diffusion barrier layer 450.

Here, the diffusion barrier layer 450 is formed between the back surface electrode layer 420 and the substrate 410. More specifically, the diffusion barrier layer 450 is formed between the substrate 410 and a portion at which the 1a-th through-region 421 is not formed in the back surface electrode layer 420. The diffusion barrier layer 450 is a member for preventing alkali ions such as Na or K ions, or Fe ions from being diffused from the substrate 410. For example, the diffusion barrier layer 450 includes at least one of oxide and nitride materials such as SiOₓ, SiNₓ, SiOₓN_{y}, Al₂O₃, AlOₓN_{y}, TiN, TaN and WN. The diffusion barrier layer 450 is formed before the formation of the back surface electrode layer 420. The diffusion barrier layer 450 is patterned together with the back surface electrode layer 420 when the 1a-th through-region 421 is formed after the formation of the back surface electrode layer 420.

As shown in FIG. 10, the solar cell 500 according to this embodiment includes a substrate 510, a back surface electrode layer 520 in which a 1a-th through-region 521 is formed, a transparent electrode layer 530 in which a 1b-th through-region 531 is formed, and a light absorbing layer 540, as described in FIG. 1. The solar cell 500 further includes a diffusion barrier layer 550.

That is, the diffusion barrier layer 550 according to this embodiment is formed between the substrate 510 and the back surface electrode layer 520. Unlike FIG. 9, the diffusion barrier layer 550 is also formed on the upper surface of the substrate 510 having the 1a-th through-region 521 formed thereon. In this embodiment, the diffusion barrier layer 550 is also formed on the upper surface of the substrate 510 having the 1a-th through-region 521 formed thereon, and thus it is possible to prevent impurities from being diffused through the 1a-th through-region 521. The diffusion barrier layer 550 is formed before the formation of the back surface electrode layer 520. The diffusion barrier layer 550 is left on the upper surface of the substrate 510 when the 1a-th through-region 521 is formed after the formation of the back surface electrode layer 520, e.g., by controlling energy of laser.

As shown in FIG. 11, the solar cell 600 according to this embodiment includes a substrate 610, a back surface electrode layer 620 in which a 1a-th through-region 621 is formed, a transparent electrode layer 630 in which a 1b-th through-region 631 is formed, and a light absorbing layer 640, as described in FIG. 1. The solar cell 600 further includes a contact resistance improving layer 650.

Here, the contact resistance improving layer 650 is a member for improving contact resistance between the transparent electrode layer 630 and the light absorbing layer 640. The contact resistance improving layer 650 is made of a p-type semiconductor material having a higher concentration of holes than that of the light absorbing layer 640. The contact resistance improving layer 650 includes at least one of MSeₓ and MSₓ (here, M is any one of Mo, W, Ta, Nb, Ti, Cr, V and Mn). The contact resistance improving layer 650 is formed between the transparent electrode layer 630 and the light absorbing layer 640. In this case, the contact resistance improving layer 650 is formed before the formation of the transparent electrode layer 630. The contact resistance improving layer 650 is patterned together with the transparent electrode layer 630 when the 1b-th through-region 631 is formed.

While the present invention has been described in connection with certain embodiments, it is to be understood that the invention is not limited to the disclosed embodiments, but, on the contrary, is intended to cover various modifications and equivalent arrangements included within the scope of the appended claims, and equivalents thereof.

## Claims

1. A solar cell, comprising:
a substrate;
a back surface electrode layer formed on the substrate, in which a 1a-th through-region is formed;
a transparent electrode layer formed on the back surface electrode layer, in which a 1b-th through-region is formed at a position corresponding to the 1a-th through-region; and
a light absorbing layer formed on the transparent electrode layer.

2. The solar cell of Claim 1 wherein the solar cell is a solar cell comprising selenium, optionally wherein the solar cell is selected from CIS, CGS, CIGS or CZTS solar cells.

3. The solar cell of any one of Claims 1 to 2, wherein the transparent electrode layer extends to cover the upper surface of the back surface electrode layer and the side surface of the back surface electrode layer, exposed by the 1a-th through-region.

4. The solar cell of Claim 3, wherein the transparent electrode layer is formed to extend on the upper surface of the substrate, exposed by the 1a-th through-region.

5. The solar cell of any one of Claims 1 to 4, wherein the transparent electrode layer is made of a transparent conductive oxide, optionally wherein the transparent conductive oxide is selected from ZnO, In₂O₃, SnO₂, TiO₂ and ZnO doped with one or more of Al, Ga and B.

6. The solar cell of any one of Claims 1 to 5, wherein the transparent electrode layer has a thickness of 50 to 150nm, optionally wherein the thickness of the transparent electrode layer positioned at the exposed side surface of the back surface electrode layer 120 is 10nm or more.

7. The solar cell of any one of Claims 1 to 6, wherein the width of the 1b-th through-region is narrower than that of the corresponding 1a-th through-region, optionally wherein:
(a) the difference in width between the 1a-th through-region and the 1b-th through-region is 10µm or more; or
(b) the difference in width between the 1a-th through-region and the first through-region is 30µm or more.

8. The solar cell of any one of Claims 1 to 7, wherein the back surface electrode layer includes at least one of Ag, Al, Cu, Au, Pt and Cr.

9. The solar cell of any one of Claims 1 to 8, wherein the solar cell further includes an adhesion improving layer formed between the back surface electrode layer and the substrate, optionally wherein the adhesion improving layer include at least one of Ti, Cr, Mo and Ni.

10. The solar cell of any one of Claims 1 to 8, wherein the solar cell further comprises a diffusion barrier layer formed between the back surface electrode layer and the substrate, optionally wherein the diffusion barrier layer is formed between the back surface electrode layer and the substrate and on the upper surface of the substrate, exposed by the 1a-th through-region.

11. The solar cell of Claim 10, wherein the wherein the diffusion barrier layer includes at least one of oxide and nitride materials, preferably selected from one or more of SiOₓ, SiNₓ, SiOₓN_{y}, Al₂O₃, AlOₓN_{y}, TiN, TaN and WN.

12. The solar cell of any one of Claims 1 to 11, wherein the solar cell further comprises a contact resistance improving layer formed between the transparent electrode layer and the light absorbing layer, optionally wherein the contact resistance improving layer includes at least one of MSeₓ and MSₓ, where M is any one of Mo, W, Ta, Nb, Ti, Cr, V and Mn.

13. The solar cell of any one of Claims 1 to 12, wherein the solar cell further comprises a buffer layer formed on the light absorbing layer, and a rear surface electrode layer formed on the buffer layer, optionally wherein the buffer layer is made of CdS or ZnS.

14. The solar cell of any one of Claims 1 to 8, 12 and 13, wherein the transparent electrode layer is formed directly onto the back surface electrode layer.

15. A method of forming a solar cell according to Claims 1 to 14, comprising the following steps:
(a) a back surface electrode layer is formed on the upper surface of a substrate;
(b) a 1a-th through region is formed in the back surface electrode layer through a patterning process, and a portion of the upper surface of the substrate is exposed to the outside by the 1a-th through-region;
(c) a transparent electrode layer is formed on the back surface electrode layer having the 1a-th through-region formed therein;
(d) a 1b-th through-region is formed in the transparent electrode layer through a patterning process to correspond to the position at which the 1a-th through-region is formed;
(e) a light absorbing layer is formed on the transparent electrode layer having the 1b-th through-region formed therein, optionally wherein:
the back surface electrode layer is formed through a sputtering, deposition, plating or screen printing process; and/or
the 1a-th through-region is formed through a laser process; and/or
the transparent electrode layer is formed through a sputtering, deposition or chemical vapor deposition (CVD) process; and/or
the 1b-th through-region is formed through a laser process.
